**Europäisches Patentamt**

**European Patent Office**

**Office européen des brevets**

(19)

(11) Veröffentlichungsnummer: **0 118 022**
**B1**

(12) # EUROPÄISCHE PATENTSCHRIFT

(45) Veröffentlichungstag der Patentschrift:
**13.01.88**

(51) Int. Cl.⁴: **H 01 L 23/40**, H 01 L 23/32

(21) Anmeldenummer: **84100998.8**

(22) Anmeldetag: **01.02.84**

(54) Stromrichtermodul mit Befestigungslaschen.

(30) Priorität: **04.03.83 DE 3307704**

(43) Veröffentlichungstag der Anmeldung:
**12.09.84 Patentblatt 84/37**

(45) Bekanntmachung des Hinweises auf die Patenterteilung:
**13.01.88 Patentblatt 88/2**

(84) Benannte Vertragsstaaten:
**DE FR GB IT NL**

(56) Entgegenhaltungen:
EP-A-0 069 901
FR-A-2 292 876
GB-A-616 165
US-A-3 305 004

PATENTS ABSTRACTS OF JAPAN, Band 7, Nr. 40 (E-159) 1185, 17. Februar 1983

(73) Patentinhaber: **BROWN, BOVERI & CIE Aktiengesellschaft, Kallstadter Strasse 1, D-6800 Mannheim 31 (DE)**

(72) Erfinder: **Neidig, Arno, Dr. Dipl.- Phys., Brühlerweg 42, D-6831 Plankstadt (DE)**
Erfinder: **Leukel, Bernd, Dipl.- Ing., Breslauer Strasse 56, D-6940 Weinheim (DE)**
Erfinder: **Hettmann, Hubert, Waldstrasse 16, D-6832 Hockenheim (DE)**

(74) Vertreter: **Kempe, Wolfgang, Dr., c/o BROWN, BOVERI & CIE AG ZPT Postfach 351, D-6800 Mannheim 31 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf ein Stromrichtermodul mit Befestigungslaschen gemäß dem Oberbegriff des Anspruchs 1.

Ein solches Stromrichtermodul mit Befestigungslaschen ist aus der DE-A-3 127 457 bekannt. Als Halbleiterbauelemente werden dabei insbesondere Thyristoren und Dioden eingesetzt.

Die Montage der Module auf einem Kühlkörper erfolgt mittels Befestigungsschrauben und Beilegscheiben. Dabei ist es von Nachteil, daß die Drehmomente für die Befestigungsschrauben auf bestimmte Werte begrenzt werden müssen, was den Einsatz eines exakt eingestellten Drehmomentschlüssels erforderlich macht. Bei Verwendung von Befestigungsschrauben mit Gewinde M5 muß das Anzugsdrehmoment z. B. auf 2Nm begrenzt werden.

Neben der Verformungsgefahr des Kunststoffs an der Druckstelle der Beilegscheibe hat die Begrenzung des Drehmomentes vor allem den Grund, eine unzulässig hohe mechanische Verspannung der Keramikplatte im Bereich der Befestigungslöcher zu vermeiden, sonst besteht die Gefahr von Keramikbrüchen, was eine mangelnde Isolationsfähigkeit zur Folge hat. Dieser Effekt macht sich besonders dann störend bemerkbar, wenn qualitativ hochwertige glasfaserverstärkte Kunststoffe für den Rahmen einschließlich Befestigungslaschen verwendet werden und wenn das Keramiksubstrat wegen der besseren Flächennutzung (bessere Wärmeabfuhr) bis nahe an die Befestigungslöcher heranreicht.

Der Erfindung liegt davon ausgehend die Aufgabe zugrunde, ein Stromrichtermodul mit Befestigungslaschen der eingangs genannten Art anzugeben, bei dem auch bei zu hohen Anzugsdrehmomenten der Befestigungsschrauben Risse in der Keramikplatte zuverlässig vermieden werden.

Diese Aufgabe wird für eine erste Variante durch die im Anspruch 1 und für eine zweite Variante durch die im Anspruch 2 gekennzeichneten Merkmale gelöst.

Die mit der Erfindung erzielbaren Vorteile bestehen insbesondere darin, daß bei beiden Varianten vermieden wird, daß sich das mechanische Spannungsfeld im Bereich der Befestigungsschrauben unmittelbar auf die spröde und bruchempfindliche Keramikplatte überträgt. Die Montage derart ausgeführter Module auf Kühlkörper wird dadurch wesentlich unkritischer. Das gleichmäßige, beidseitige Festziehen der Befestigungsschrauben mit einem Drehmomentschlüssel kann entfallen.

Ausführungsbeispiele der Erfindung sind nachfolgend anhand der Zeichnungen erläutert.
Es zeigen:
Fig. 1 einen Schnitt durch die Breitseite einer ersten Stromrichtermodulvariante,
Fig. 2 eine Draufsicht auf die erste Stromrichtermodulvariante,
Fig. 3 einen Schnitt durch die Breitseite einer zweiten Stromrichtermodulvariante,
Fig. 4 die zweite Stromrichtermodulvariante in einer Ansicht von unten.

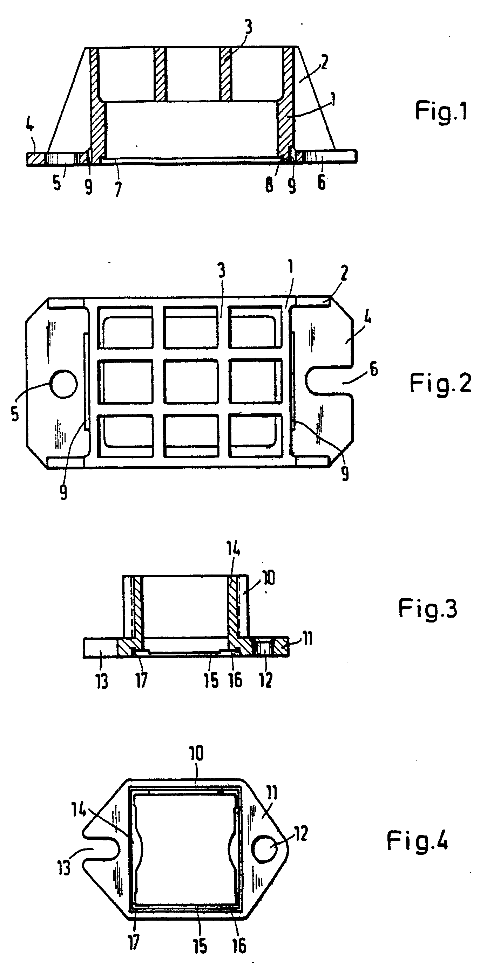

In Fig. 1 ist ein Schnitt durch die Breitseite einer ersten Stromrichtermodulvariante dargestellt. Das Modul besitzt einen oben und unten offenen Rahmen 1, der als Gehäusewandung dient. Der Rahmen 1 weist an seinen beiden Schmalseiten Versteifungskanten 2 auf. Zur Erhöhung der Stabilität besitzt der Rahmen 1 ferner mehrere parallel zur Breitseite bzw. Schmalseite verlaufende Rippen 3. Beim Stromrichtermodul der ersten Variante verlaufen zwei Rippen 3 parallel zur Breitseite und zwei Rippen 3 parallel zur Schmalseite. Hierdurch ergeben sich neun rechteckförmige Zellen zur Aufnahme von nicht dargestellten elektrischen Anschlußelementen (Steckkontakten, vorzugsweise Flachsteckern) für das Modul. Die Rippen 3 dienen zur Kriechwegverlängerung zwischen den Anschlußelementen. Der Rahmen 1 weist an seinen beiden Schmalseiten in Höhe der Bodenfläche Befestigungslaschen 4 auf. Diese Befestigungslaschen 4 sind mit einer Bohrung 5 bzw. einer U-förmigen Ausnehmung 6 zur Montage des Stromrichtermoduls auf einem Kühlkörper versehen.

Das Gehäuse des Stromrichtermoduls wird zum einen durch den Rahmen 1, zum anderen durch eine in eine umlaufende Vertiefung 7 der Bodenfläche des offenen Rahmens 1 aufgesetzte, nicht dargestellte Keramikplatte gebildet. Diese Keramikplatte ist mit Metallisierungen als Leiterbahnen und Kontaktflächen zum Auflöten von Anschlußelementen, Halbleiterbauelementen (vorzugsweise Thyristoren und Dioden) und internen Verbindungslaschen in hybrider Aufbauweise versehen.

Der Rahmen 1 und die nicht dargestellte Keramikplatte werden miteinander verklebt. Zur genauen Fixierung der Keramikplatte weist der Rahmen 1 die bereits erwähnte umlaufende Vertiefung 7 in seiner Bodenfläche auf, deren Tiefe ungefähr der Dicke der Keramikplatte entspricht. Eine in dieser Vertiefung 7 des Rahmens 1 vorgesehene umlaufende Nut 8 dient dabei zur Aufnahme von austretendem Klebstoff. Der überschüssige Klebstoff wandert in die Nut 8 und quillt nicht über den Rand der Keramikplatte auf die Kühlfläche.

Zwischen Gehäusewand und Bohrung 5 bzw. zwischen Gehäusewand und U-förmiger Ausnehmung 6 ist jeweils ein Schlitz 9 vorgesehen. Die beiden Schlitze 9 verhindern eine Übertragung von mechanischen Spannungen im Bereich der Befestigungsschrauben der Bohrung 5 bzw. der U-förmigen Ausnehmung 6 auf die Keramikplatte bei Montage des Moduls auf einem Kühlkörper. Die Anzugsdrehmomente für die Befestigungsschrauben müssen nicht mehr begrenzt werden, d. h. ein Drehmomentschlüssel ist zur Montage des Moduls nicht mehr erforderlich.

Das Stromrichtermodul ist in seinem unteren Teil mit einer weichen Vergußmasse, z. B. Silikonkautschuk, und in seinem mittleren Teil mit einer harten Vergußmasse, z. B. Epoxidharz, vergossen.

Als Material für den Rahmen 1 einschließlich Versteifungskanten 2, Rippen 3 und Befestigungslaschen 4 wird vorzugsweise ein hochwertiger glasfaserverstärkter Kunststoff verwendet.

In Fig. 2 ist eine Draufsicht auf die erste Stromrichtermodulvariante dargestellt. Im wesentlichen sind die durch die Wandung des Rahmens 1 und die Rippen 3 gebildeten neun rechteckförmigen, zur Aufnahme von Anschlußelementen dienenden Zellen sowie die Befestigungslaschen 4 mit Befestigungslöchern 5, 6 erkennbar. Der zwischen Rahmenwandung und Bohrung 5 bzw. U-förmiger Ausnehmung 6 vorgesehene Schlitz 9 entspricht in seiner Länge etwa der halben Breite des Moduls.

In Fig. 3 ist ein Schnitt durch die Breitseite einer zweiten, vorzugsweise für Leistungstransistoren geeigneten Stromrichtermodulvariante dargestellt. Dieses Stromrichtermodul ist kleiner und kompakter aufgebaut als die erste Modulvariante und besitzt ebenfalls einen oben und unten offenen Rahmen 10 als Gehäusewandung. Zur Montage des Moduls auf einem Kühlkörper sind wie bei der ersten Stromrichtermodulvariante Befestigungslaschen 11 in Höhe der Bodenfläche mit einer (angefasten) Bohrung 12 bzw. einer U-förmigen Aussparung 13 vorgesehen. Da diese Befestigungslöcher infolge des kompakten Modulaufbaues sehr nahe an der Gehäusewandung liegen, besitzt der Rahmen 10 am Ort der Befestigungslöcher in das Gehäuseinnere ragende, halbkreisförmige Ausnehmungen 14. Diese Ausnehmungen 14 sind so bemessen, daß die Befestigungslöcher bequem mit Beilegscheiben versehen werden können und eine anschließende Verschraubung mittels Befestigungsschrauben in einfacher Weise erfolgen kann.

Zur Fixierung der mit dem Rahmen 10 zu verklebenden, elektrisch isolierenden Keramikplatte ist wiederum eine umlaufende Vertiefung 15 im Bodenteil des Rahmens 1 vorgesehen. Diese umlaufende Vertiefung 15, deren Tiefe höchstens der Dicke der Keramikplatte entspricht, ist mit Abstufungen derart versehen, daß sich im Bereich der mit den Befestigungslaschen 11 versehenen beiden Rahmenwandungen eine spaltförmige Aussparung 16 zwischen umlaufender Vertiefung und aufgesetzter Keramikplatte ergibt. Im Bereich der übrigen beiden Rahmenwandungen stützt sich die Keramikplatte direkt an der umlaufenden Vertiefung 15 ab.

Zur Aufnahme eventuell austretenden Klebstoffes ist wiederum eine umlaufende Nut 17 vorgesehen.

Auch bei dieser zweiten Stromrichtermodulvariante wird eine Übertragung von mechanischen Spannungen im Bereich der Befestigungslaschen 11 auf die Keramikplatte vermieden, und zwar durch die Abstufung der umlaufenden Vertiefung 15 im Gehäuseboden. Diese Abstufung verhindert infolge der vorhandenen spaltförmigen Aussparung 16 einen direkten Kontakt des den Befestigungslaschen 11 zugewandten Teils der umlaufenden Vertiefung 15 mit der Keramikplatte. Werden die Befestigungsschrauben mit zu hohem Anzugsdrehmoment festgezogen, so wird der mit der spaltförmigen Aussparung 16 versehene Teil der umlaufenden Vertiefung 15 zur Keramikplatte hin verformt. Die Spaltbreite der Aussparung 16 ist jedoch so bemessen, daß bei dieser Verformung keinesfalls mechanische Spannungen auf die Keramikplatte übertragen werden.

In Fig. 4 ist die zweite Stromrichtermodulvariante in einer Ansicht von unten dargestellt, wobei insbesondere die Abstufung der umlaufenden Vertiefung 15 im Bodenteil des Rahmens 10 zu erkennen ist.

Die Übertragung von mechanischen Spannungen auf die Keramikplatte kann gemäß der zweiten Variante insbesondere bei den Stromrichtermodulen verhindert werden, bei denen der Platz zwischen Rahmenwandung und Befestigungsloch zu eng für die Anordnung eines Schlitzes ist.

**Patentansprüche**

1. Stromrichtermodul mit einem oben und unten offenen Rahmen als Gehäusewandung und einer in einer umlaufenden Vertiefung der Bodenfläche des Rahmens eingesetzten Keramikplatte als Gehäuseboden, wobei die Keramikplatte auf ihrer dem Gehäuseinneren zugewandten Seite mit Halbleiterbauelementen, internen Verbindungslaschen und außerhalb des Gehäuses frei zugänglichen Anschlußelementen versehen ist und Befestigungslaschen am Rahmen mit Befestigungslöchern zur Montage des Moduls auf einem Kühlkörper vorgesehen sind, dadurch gekennzeichnet, daß die Befestigungslaschen (4) zwischen den Wandungen des Rahmens (1) und den Befestigungslöchern (5, 6) mit Schlitzen (9) versehen sind.

2. Stromrichtermodul mit einem oben und unten offenen Rahmen als Gehäusewandung und einer in einer umlaufenden Vertiefung der Bodenfläche des Rahmens eingesetzten Keramikplatte als Gehäuseboden, wobei die Keramikplatte auf ihrer dem Gehäuseinneren zugewandten Seite mit Halbleiterbauelementen, internen Verbindungslaschen und außerhalb des Gehäuses frei zugänglichen Anschlußelementen versehen ist und Befestigungslaschen am Rahmen mit Befestigungslöchern zur Montage des Moduls auf einem Kühlkörper vorgesehen sind, dadurch gekennzeichnet, daß die umlaufende Vertiefung (15) der Bodenfläche des Rahmens (1) mit Abstufungen derart versehen ist, daß sich im Bereich der mit den Befestigungslaschen (11) versehenen beiden Rahmenwandungen eine spaltförmige Aussparung (16) zwischen umlaufender Vertiefung (15) und Keramikplatte ergibt und sich die Keramikplatte nur im Bereich der übrigen beiden Rahmenwandungen direkt an der umlaufenden Vertiefung (15) abstützt.

## Claims

1. Power converter module with an upper and a lower open frame as housing wall and a ceramic plate, inserted in a peripheral recess of the bottom surface of the frame, as housing base, the ceramic plate being provided on its side facing the housing interior with semiconductor components, internal connecting links and terminal elements, which are freely accessible outside the housing, and fastening links being provided on the frame with fastening holes for the installation of the module on a heat sink, characterized in that the fastening links (4) are provided with slots (9) between the walls of the frame (1) and the fastening holes (5, 6).

2. Power converter module with an upper and a lower open frame as housing wall and a ceramic plate, inserted in a peripheral recess of the bottom surface of the frame, as housing base, the ceramic plate being provided on its side facing the housing interior with semiconductor components, internal connecting links and terminal elements, which are freely accessible outside the housing, and fastening links being provided on the frame with fastening holes for installation of the module on a heat sink, characterized in that the peripheral recess (15) of the bottom surface of the frame (1) is provided with graduations in such a way that a gap-like relief (16) is produced between the peripheral recess (15) and the ceramic plate in the region of the two frame walls provided with the fastening links (11) and the ceramic plate is supported directly on the peripheral recess (15) only in the region of the remaining two frame walls.

## Revendications

1. Module convertisseur de courant comportant un cadre à dessus et dessous ouverts, constituant une paroi de boîtier, et, en tant que fond de boîtier, une plaque en céramique insérée dans une dépression périphérique de la surface de fond du cadre, la plaque en céramique étant munie, sur sa face tournée vers l'intérieur du boîtier, d'éléments semiconducteurs, de pattes de liaison internes, et, à l'extérieur du boîtier, d'éléments de raccordement librement accessibles, et des oreilles de fixation avec trous de fixation pour monter le module sur un refroidisseur étant prévues sur le cadre, caractérisé par le fait que les oreilles de fixation (4) sont munies de fentes (9) entre les parois du cadre (1) et les trous de fixation (5, 6).

2. Module convertisseur de courant comportant un cadre à dessus et dessous ouverts, constituant une paroi de boîtier, et, en tant que fond de boîtier, une plaque en céramique insérée dans une dépression périphérique de la surface de fond du cadre, la plaque en céramique étant munie, sur son côté tourné vers l'intérieur du boîtier, d'éléments semiconducteurs, de pattes de liaison interne, et, à l'extérieur du boîtier, d'éléments de raccordement librement accessibles, et des oreilles de fixation avec trous de fixation pour monter le module sur un refroidisseur étant prévues sur le cadre, caractérisé par le fait que la dépression périphérique (15) de la surface de fond du cadre (1) est munie de gradins tels qu'il y ait, dans la région des deux parois du cadre munies des oreilles de fixation (11), un évidement en forme d'interstice (16) entre dépression périphérique (15) et plaque en céramique, et que la plaque en céramique ne prenne appui directement sur la dépression périphérique (15) que dans la région des deux autres parois du cadre.

Fig.1

Fig.2

Fig.3

Fig.4